(19) **Europäisches Patentamt / European Patent Office / Office européen des brevets**

(11) **EP 1 873 835 A2**

(12) **EUROPEAN PATENT APPLICATION**

(43) Date of publication:
**02.01.2008 Bulletin 2008/01**

(51) Int Cl.:
*H01L 27/146* (2006.01)

(21) Application number: **07107607.9**

(22) Date of filing: **07.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **30.06.2006 JP 2006181997**
**19.12.2006 JP 2006341530**

(71) Applicant: **MATSUSHITA ELECTRIC INDUSTRIAL CO., LTD**
**Kadoma-shi, Osaka 571-8501 (JP)**

(72) Inventors:
• **Minamio, Masanori**
  **Osaka 540-6319 (JP)**
• **Maruo, Tetsumasa**
  **Osaka 540-6319 (JP)**
• **Itoi, Kiyokazu**
  **Osaka 540-6319 (JP)**
• **Fukuda, Toshiyuki**
  **Osaka 540-6319 (JP)**

(74) Representative: **Zimmer, Franz-Josef**
**Grünecker, Kinkeldey,**
**Stockmair & Schwanhäusser**
**Anwaltssozietät**
**Maximilianstrasse 58**
**80538 München (DE)**

(54) **Solid state image pickup device and method for manufacturing the same**

(57)    A solid state image pickup device **1** includes a substrate **10** on which a solid state image pickup element **14** is mounted and a transparent component **11**. A polymerization initiator for bonding the substrate **10** and the transparent component **11** is onium salt having a halogen-containing aromatic compound as an anion.

FIG. 1A

FIG. 1B

**Description**

BACKGROUND OF THE INVENTION

1. Field of the Invention

The present invention relates to a solid state image pickup device including a solid state image pickup element placed in a housing and a method for manufacturing the same, as well as a semiconductor device including a semiconductor element placed in a housing and a method for manufacturing the same.

2. Description of Related Art

A conventional solid state image pickup device, such as a CCD or a CMOS, includes a solid state image pickup element placed in a cavity of a package body, a transparent component arranged to cover the cavity and a resin adhesive for bonding the transparent component to the package body (for example, see Japanese Unexamined Patent Publication No. H10-321749). This structure is also applicable to semiconductor devices including sound sensor elements, pressure sensor elements, acceleration sensor elements, laser elements, LEDs or photodiodes as semiconductor elements.
In this structure, the solid state image pickup element is bonded to a surface in the cavity of the package body by die bonding. Connection terminals of the package body and Al electrodes of the solid state image pickup element are connected by wire bonding, and then the cavity is covered with the transparent component. The transparent component is bonded to the package body using a resin adhesive. The resin adhesive is generally a thermosetting resin or a UV curable resin.
On the surface of the solid state image pickup element, lenses made of an acrylic resin called on-chip lenses are formed to enhance light gathering efficiency. However, the on-chip lenses have a problem of heat resistance. To be more specific, the microlenses are softened and deformed when heat is applied thereto for a long time. Therefore, it is necessary to cure the resin adhesive in a short time at low temperature as possible. From this point of view, the UV curable resin is preferably used. The UV curable resin is receiving attention from the aspect of working efficiency.
As the solid state image pickup element is enclosed in the cavity of the package body, humidity mixed into the cavity from outside may possibly be condensed on the inner surface of the transparent component, or alternatively, wires of the solid state image pickup element may be corroded. To eliminate these drawbacks, a hygroscopic resin is arranged in the cavity to adsorb the humidity (for example, see Japanese Unexamined Patent Publication 2004-22928).
Further, as a polymerization initiator contained in the UV curable resin, various kinds of onium salts have been considered, for example, iodonium salt, sulfonium salt and phosphonium salt. A system containing the onium salt is stable at room temperature and shows high reaction rate when heated or exposed to light. However, since the onium salt is an acidic substance, a resin cured using the onium salt gives an acidic extract in a moisture resistance test. This is because the onium salt remaining in the cured resin adhesive is liberated from the resin in the presence of humidity, thereby corroding the electronic parts. Accordingly, it has been proposed to add an alkaline filler to the resin in order to neutralize the resin and prevent the corrosion (for example, see Japanese Unexamined Patent Publication No. 2000-264955).

SUMMARY OF THE INVENTION

According to Japanese Unexamined Patent Publication H10-321749 described above, a compound liberated from the resin adhesive is not taken into account. Therefore, under high temperature and high humidity condition, the compound liberated from the resin adhesive brings about corrosion of the wires of the solid state image pickup element. As a result, the Al electrodes of the solid state image pickup element may be corroded or the connection between the Al electrodes and Au wires may become deteriorated.
According to Japanese Unexamined Patent Publication No. 2004-22928, the hygroscopic substance placed in the cavity of the package body adsorbs humidity even if it is mixed into the cavity. Therefore, the condensation on the inner surface of the transparent component is prevented. However, ionic substances and gases liberated from the resin adhesive cannot be adsorbed. Further, according to Japanese Unexamined Patent Publication No. 2000-264955, it is considered that the alkaline filler is able to neutralize the onium salt liberated from the cured resin adhesive. However, depending on the combination of a cation and an anion in the onium salt, reliability of the solid state image pickup device may significantly be impaired by the cation and the anion liberated from the onium salt.
The present invention has been achieved to solve the above-described problems. An object of the present invention is to provide a solid state image pickup device capable of preventing the corrosion of an alloy layer formed on an interface between Au wires and Al electrodes even under high temperature and high humidity condition.
In order to achieve the above-described object, a first solid state image pickup device of the present invention includes: a solid state image pickup element including an image pickup region and a plurality of bonding pads; a substrate having a recess and containing the solid state image pickup element; a plurality of connection terminals formed in the recess of the substrate; Au wires for electrically connecting the bonding pads and the connection terminals; a transparent component placed on a top surface of the substrate; and a resin adhesive for bonding the substrate and the transparent component, wherein the resin adhesive contains an epoxy resin, a polymerization initiator and organic peroxide and the polymerization initiator contains onium salt having a halogen-containing aromatic compound as an anion.

According to this configuration, substances in the resin adhesive for bonding the transparent component and the substrate are prevented from liberating from the resin adhesive even if the solid state image pickup device is present in high temperature and high humidity environment. Therefore, the solid state image pickup device is provided with high reliability.

In order to achieve the above-described object, a second solid state image pickup device of the present invention includes: a solid state image pickup element including an image pickup region and a plurality of bonding pads; a substrate on which the solid state image pickup element is mounted; a rib formed on the substrate; a plurality of connection terminals formed on the substrate; Au wires for electrically connecting the bonding pads and the connection terminals; a transparent component placed above the substrate and bonded to a top surface of the rib; and a resin adhesive for bonding the top surface of the rib and the transparent component, wherein the resin adhesive contains an epoxy resin, a polymerization initiator and organic peroxide and the polymerization initiator contains onium salt having a halogen-containing aromatic compound as an anion.

With this configuration, there is no need of using a substrate which is prepared by a complicated fabrication process. Therefore, the solid state image pickup device is provided at lower cost.

With respect to the above-described configurations, it is preferable that the halogen-containing aromatic compound is a fluorine-containing aromatic compound.

With this configuration, the reaction rate is increased and halogen is less likely to be liberated from the cured resin adhesive. Therefore, the solid state image pickup device is provided with high reliability.

With respect to the above-described configurations, it is preferable that the halogen-containing aromatic compound is a borate compound.

Further, it is preferable that the content of the polymerization initiator in the resin adhesive is higher than 0.5 wt% and less than 7 wt%.

With this configuration, the content of the polymerization initiator remains unreacted in the cured adhesive resin is reduced and the substances in the cured resin adhesive are less likely to be liberated. Therefore, the solid state image pickup device is provided with high reliability.

With respect to the above-described configurations, it is preferable that the bonding pads of the solid state image pickup element are Al electrodes and the ratio of an alloy formed on an interface between the Au wires and the Al electrodes is 50% or higher.

With this configuration, the solid state image pickup device is provided with great safety against the corrosion of an Au-Al alloy formed on the interface between the Au wires and the Al electrodes.

With respect to the above-described configurations, it is preferable that the substrate is a ceramic substrate.

Since the ceramic substrate is less hygroscopic and capable of reducing the amount of humidity mixed into the cavity of the substrate, the solid state image pickup device is provided with high reliability.

With respect to the above-described configurations, it is preferable that the substrate is a resin substrate using glass fabric epoxy or aramid as a base material.

Since the resin substrate is lighter in weight than the ceramic substrate, the weight of the solid state image pickup device is reduced. This contributes to weight reduction of mobile devices.

BRIEF DESCRIPTION OF THE DRAWINGS

FIG. **1A** is a schematic perspective view illustrating the structure of a solid state image pickup device of a first embodiment of the present invention and FIG. **1B** is a schematic perspective view illustrating the inside structure thereof.

FIG. **2A** is a schematic plan view partially broken away and FIG. **2B** is a sectional view taken along the line A-A shown in FIG. **2A.**

FIGS. **3A** to **3E** are flow diagrams illustrating a method for manufacturing the solid state image pickup device of the first embodiment of the present invention.

FIG. **4A** is a schematic sectional view illustrating the vicinity of an Al electrode of the solid state image pickup device of the first embodiment of the present invention and FIG. **4B** is a schematic sectional view taken along the line B-B shown in FIG. **4A.**

FIG. **5A** is a schematic perspective view illustrating the structure of a solid state image pickup device of a second embodiment of the present invention and FIG. **5B** is a schematic perspective view illustrating the inside structure thereof.

FIG. **6A** is a schematic plan view of the solid state image pickup device of the second embodiment of the present invention and FIG. **6B** is a sectional view taken along the line C-C shown in FIG. **6A.**

FIGS. **7A** to **7F** are flow diagrams illustrating a method for manufacturing the solid state image pickup device of the second embodiment of the present invention.

FIG. **8A** is a schematic perspective view illustrating a semiconductor device of a third embodiment of the present invention with a cover detached and FIG. **8B** is a schematic perspective view of the same with the cover attached.

FIG. **9A** is a schematic plan view, partially broken away, of a semiconductor device of a fourth embodiment of the present invention and FIG. **9B** is a sectional view taken along the line A-A shown in FIG. **9A.**

FIG. **10A** is a schematic plan view, partially broken away, of a semiconductor device of a fifth embodiment of the present invention and FIG. **10B** is a sectional view taken along the line C-C shown in FIG. **10A.**

## DETAILED DESCRIPTION OF THE INVENTION

Hereinafter, explanation of embodiments of the present invention is provided with reference to the drawings. In the drawings, the thicknesses and lengths of components depicted are different from actual ones for convenience sake. The same is applied to the number of electrodes and terminals of the components. Further, materials for the components are not limited to those described below.

(First Embodiment)

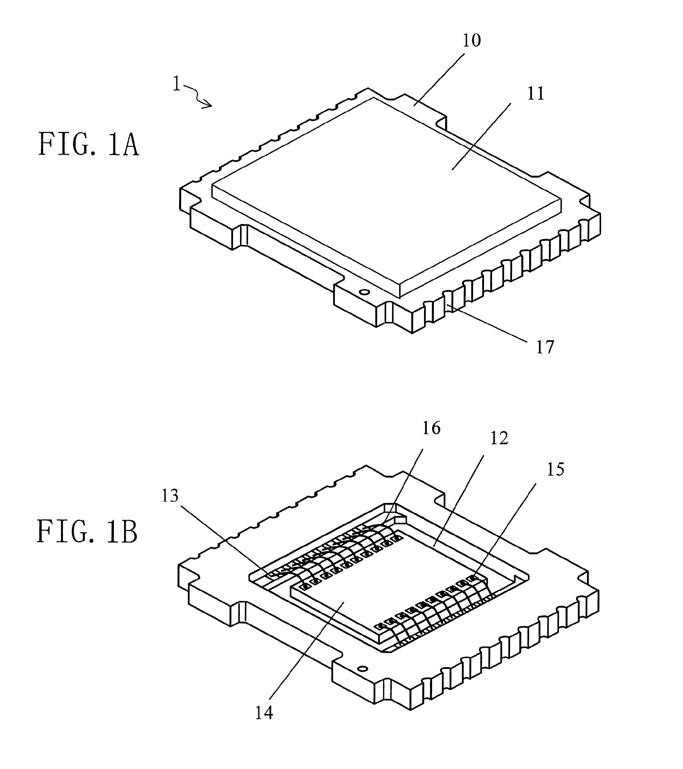

FIG. **1A** is a schematic perspective view illustrating a solid state image pickup device **1** of a first embodiment and FIG. **1B** is a schematic perspective view illustrating the solid state image pickup device **1** of FIG. **1A** from which a transparent component **11** and a resin adhesive are removed.

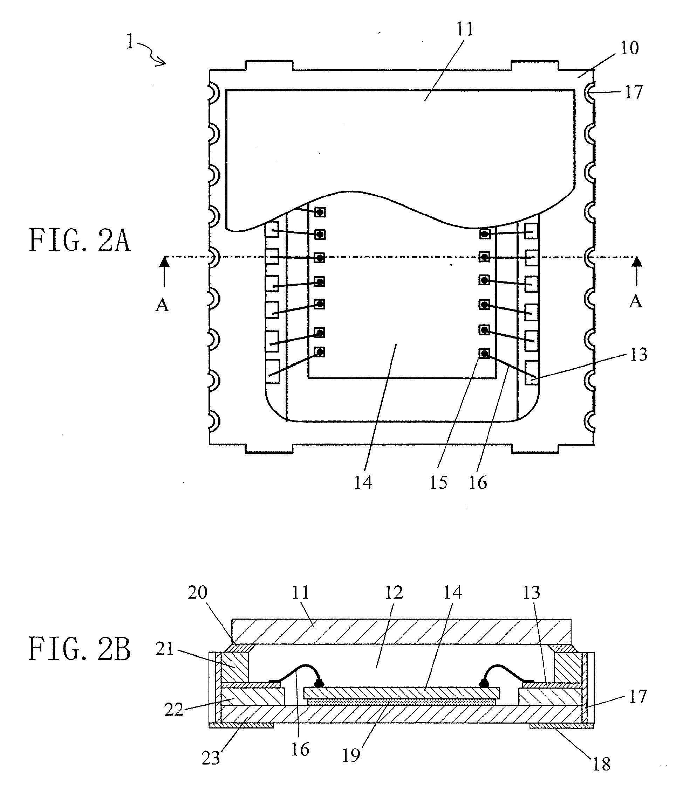

FIG. **2A** is a schematic plan view of the solid state image pickup device **1** of the present embodiment and FIG. **2B** is a sectional view taken along the line A-A of FIG. **2A.**

The solid state image pickup device **1** of the present embodiment includes a recessed substrate **10** having a cavity **12** in the middle portion thereof. The substrate **10** includes a plurality of connection terminals **13** formed on the top surface of an intermediate layer **22** exposed in the cavity **12**, a plurality of external side electrodes **17** formed on the end faces of the substrate **10** and a plurality of external bottom electrodes **18** formed on the bottom surface of the substrate **10.** The solid state image pickup device **1** further includes a solid state image pickup element **14** having a plurality of Al electrodes **15,** Au wires **16** for electrically connecting the connection terminals **13** formed on the intermediate layer **22** of the substrate **10** and the Al electrodes (bonding pads) **15,** a transparent component **11** covering the cavity **12** of the substrate **10** and a resin adhesive **20** for bonding a topmost layer **21** of the substrate **10** and the transparent component **11**.

The substrate **10** is made of the intermediate layer **22** and the topmost layer **21** which are frame-shaped and stacked on the periphery of a substantially rectangular bottommost layer **23**. Space enclosed with the intermediate layer **22** and the topmost layer **21** is the cavity **12**. The topmost layer **21** is provided on the periphery of the intermediate layer **22**. That is, the bottommost to topmost layers **23** to **21** are stacked in the form of a staircase. The transparent component **11** is fixed onto the top surface of the topmost layer **21** to cover the cavity **12**, i.e., on the top surface of the substrate **10**.

This package has a so-called LCC (leadless chip carrier) structure, which is one of the packages reduced in size and thickness.

In the present embodiment, the substrate **10** is a ceramic substrate.

The ceramic substrate **10** includes three insulating ceramic layers. The ceramic material may be a sintered body of alumina or aluminum nitride or a sintered body of glass-added ceramic material obtained by low-temperature firing. Alternatively, a resin material added with ceramic powder may be molded into the substrate. If high heat transfer property is required, the sintered body of ceramic material such as alumina is preferably used.

The connection terminals **13** may be obtained by forming a copper layer on the top surface of the intermediate layer **22** of the substrate **10** by a combined use of electroless plating and electroplating and patterning the copper layer into desired shape by etching. Alternatively, the connection terminals **13** may be formed by printing using Cu paste, Ag paste or W paste.

The external side electrodes **17** are in the form of halves of through holes penetrating the substrate **10** from the top surface to the bottom surface thereof. The external side electrodes **17** may be obtained by forming a copper layer on semicircular recesses by a combined use of electroless plating and electroplating and patterning the copper layer into desired shape by etching. Alternatively, the external side electrodes **17** may be formed by printing using metal paste such as Cu paste, Ag paste or W paste.

The external bottom electrodes **18** may be obtained by forming a copper layer on the bottom surface of the bottommost layer **23** of the substrate **10** by a combined use of electroless plating and electroplating and patterning the copper layer into desired shape by etching. Alternatively, the external bottom electrodes **18** may be formed by printing using metal paste such as Cu paste, Au paste or W paste.

The external side electrodes **17** are connected to the connection terminals **13** at the semicircular recesses formed in the end faces of the substrate **10.** The Al electrodes **15** of the solid state image pickup element **14** are connected to the connection terminals **13** with the Au wires **16.** The connection terminals **13** are electrically connected to the external side electrodes **17** and the external bottom electrodes **18.**

It is preferable to form a thin gold film (not shown) on the surfaces of the connection terminals **13,** external side electrodes **17** and external bottom electrodes **18.** The thin gold film may preferably be provided by forming a nickel plating layer on the thick copper plating wires and forming a thin gold film thereon by plating. By so doing, ball bonding of the Au wires to the connection terminals **13** is performed with improved bondability. Further, during the soldering of the solid state image pickup device **1** to a mother board, the external side electrodes **17** and the external bottom electrodes **18** show improved wettability, thereby enhancing the reliability of the soldered joints. The connection terminals, external side electrodes and external bottom electrodes may be formed by printing and baking W paste and then forming a Ni plating layer and an Au plating layer thereon.

The solid state image pickup element **14** is bonded to the bottom surface of the cavity **12** of the substrate **10** with a die bonding agent **19.** Examples of the die bonding agent **19** include thermosetting resin paste such as an epoxy resin and a polyimide resin and an adhesive tape made of an epoxy resin or a polyimide resin. If high heat transfer property is required, it is preferable to use resin paste with a metallic filler such as Ag dispersed therein.

The resin adhesive **20** may be a thermosetting resin or a UV curable resin. In particular, the UV curable resin is preferable because it cures at a lower temperature in a shorter time as compared with the thermosetting resin and less likely to cause thermal damage to the solid state image pickup element **14,** especially to the on-chip lenses formed on an image pickup region of the solid state image pickup element **14.** Further, cycle time of the manufacture is reduced.

The resin adhesive **20** used in the present embodiment contains an epoxy resin [A], a polymerization initiator [B], organic peroxide [C] and a filler [D].

Examples of the epoxy resin [A] include bisphenol epoxy resins, novolac epoxy resins and biphenyl epoxy resins. Among the bisphenol epoxy resins, a bisphenol A epoxy resin, a bisphenol S epoxy resin and a bisphenol F epoxy resin are preferable and generally used because they are in the liquid state at room temperature.

The polymerization initiator [B] according to the present embodiment is onium salt containing a cation and an anion. Examples of the onium cation include iodonium, sulfonium, selenonium, phosphonium and ammonium. The onium anion is preferably a halogen-containing aromatic compound. Due to covalent bonding of halogen and aromatic carbon, the onium salt is less likely to dissociate even at high temperature and high humidity and the cured resin is improved in stability. Even if liberated halogen ions corrode the Al electrodes or iodonium salt is used as the cation of the onium salt, separation of iodine is prevented. Thus, secondary effect such as corrosion of Au is also prevented. In particular, onium salt containing a fluorine-containing aromatic compound as the anion is preferable because it is stable and increases the cure rate.

The halogen-containing aromatic compound may be a borate compound. Suitable examples thereof include diphenyliodonium tetrakis(pentafluorophenyl)borate, bis(p-octadecylphenyl)iodonium tetrakis(pentafluorophenyl)borate, bis(p-octadecyloxyphenyl)iodonium tetrakis(pentafluorophenyl)borate, phenyl(p-octadecyloxyphenyl)iodonium tetrakis(pentafluorophenyl)borate, diphenyliodonium tetrafluoroborate, diphenyliodonium hexafluorophosphonate, diphenyliodonium hexafluoroarsenate, diphenyliodonium trifluoromethanesulfonate, diphenyliodonium trifluoroacetate, diphenyliodonium-p-toluenesulfonate, 4-methoxyphenylphenyliodonium tetrafluoroborate, 4-methoxyphenylphenyliodonium hexafluorophosphonate, 4-methoxyphenylphenyliodonium hexafluoroarsenate, 4-methoxyphenylphenyliodonium trifluoromethane, dimethyl(benzyl)sulfonium tetrakis[3,5-bis(trifluoromethyl)phenyl]borate, dimethyl(p-bromobenzyl)sulfonium tetrakis[3,5-bis(trifluoromethyl)phenyl]borate, dimethyl(p-cianobenzyl)sulfonium tetrakis[3,5-bis(trifluoromethyl)phenyl]borate, dimethyl(m-nitrobenzyl)sulfonium tetrakis[3,5-bis(trifluoromethyl)phenyl]borate, dimethyl(pentafluorophenylmethyl)sulfonium tetrakis[3,5-bis(trifluoromethyl)phenyl]borate, dimethyl(p-(trifluoromethyl)benzyl)sulfonium tetrakis[3,5-bis(trifluoromethyl)phenyl]borate, dimethyl(p-(methylsulfonylbenzyl)sulfonium tetrakis[3,5-bis(trifluoromethyl)phenyl]borate, dimethyl(o-acetylbenzyl)sulfonium tetrakis[3,5-bis(trifluoromethyl)phenyl]borate, dimethyl(o-benzoylbenzyl)sulfonium tetrakis[3,5-bis(trifluoromethyl)phenyl]borate, dimethyl(p-isopropylbenzyl)sulfonium tetrakis[3,5-bis(trifluoromethyl)phenyl]borate, dimethyl(p-methoxybenzyl)sulfonium tetrakis[3,5-bis(trifluoromethyl)phenyl]borate, dimethyl(2-naphthylmethyl)sulfonium tetrakis[3,5-bis(trifluoromethyl)phenyl]borate, dimethyl(9-anthrylmethyl)sulfonium tetrakis[3,5-bis(trifluoromethyl)phenyl]borate, diethyl(benzyl)sulfonium tetrakis[3,5-bis(trifluoromethyl)phenyl]borate, methylethyl(benzyl)sulfonium tetrakis[3,5-bis(trifluoromethyl)phenyl]borate, methylphenyl(benzyl)sulfonium tetrakis[3,5-bis(trifluoromethyl)phenyl]borate and diphenyl(benzyl)sulfonium tetrakis[3,5-bis(trifluoromethyl)phenyl]borate.

The content of the polymerization initiator in the resin adhesive is preferably higher than 0.5 wt% and less than 7.0 wt%. If the content is 7.0 wt% or higher, the polymerization occurs abruptly and adhesion between the resin adhesive and the transparent component is reduced. Further, if the content is 0.5 wt% or lower, the polymerization does not occur sufficiently and the adhesion is reduced.

Examples of the organic peroxide [C] of the present embodiment include aliphatic, alicyclic and aromatic organic peroxides. Suitably used are 1,1-bis(t-butylperoxy) 3,3,5-trimethylcyclohexane and t-butylperoxy benzonate.

The filler [D] of the present embodiment may be an inorganic filler such as talc, mica, $Al_2O_3$, MgO, BN, AlN or $SiO_2$. The filler alleviates thermal distortion at the joints between different materials used to form the package. Therefore, the filler is used to reduce the difference in linear expansion coefficient between the adhesive and the adherend component.

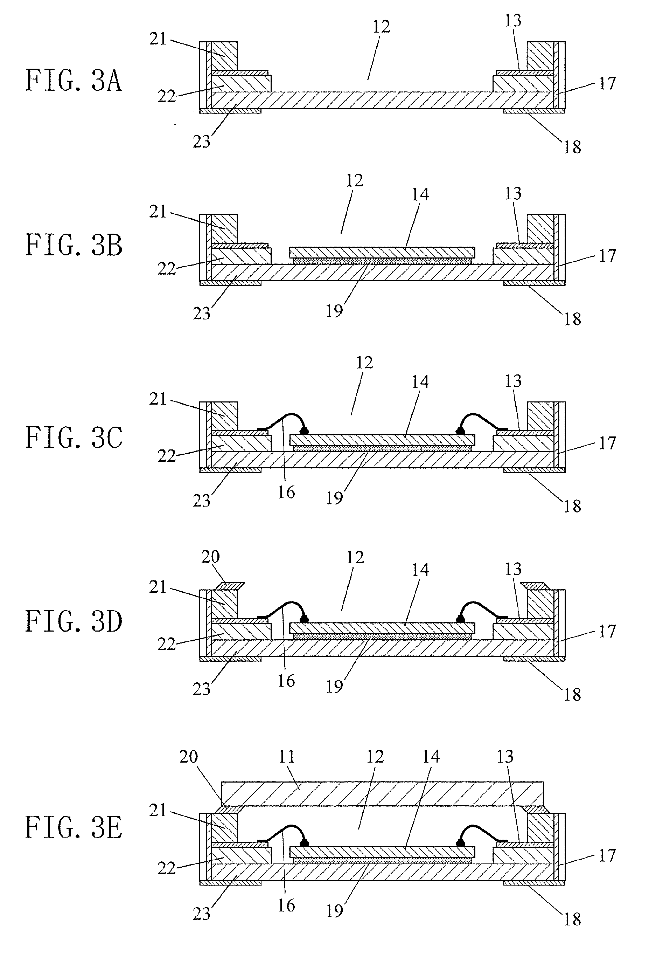

Hereinafter, brief explanation of a method for manufacturing the solid state image pickup device of the present embodiment is provided with reference to FIGS. **3A** to **3E.**

Referring to FIG. **3A,** a die bonding agent **19** is applied to the middle of the bottom surface of the cavity **12** (the top surface of the bottommost layer **23)** of the substrate **10** using a dispenser. The dispenser may have a single nozzle or multiple nozzles. The die bonding agent **19** may be applied by a transfer method such as stamping. The die bonding agent **19** may be thermosetting paste containing a thermosetting resin such as an epoxy resin or a polyimide resin as a main ingredient. The epoxy resin may preferably be bisphenol epoxy resins, novolac epoxy resins or biphenyl epoxy resins. Among the bisphenol epoxy resins, a bisphenol A epoxy resin, a bisphenol S epoxy resin and a bisphenol F epoxy resin are preferable and generally used because they are in the liquid state at room temperature. If high heat transfer property is required, it is preferable to use resin paste with a metallic filler such as Ag dispersed therein. The thermosetting resin paste may be replaced with an adhesive tape containing the thermosetting resin such as the epoxy resin or the polyimide resin as a main ingredient. The adhesive tape is bonded to the rear surface of a wafer before separating the solid state image pickup elements **14** by dicing such that it is cut together with the solid state image pickup elements **14.** In this way, the solid state image pickup elements **14** are provided with the adhesive tape bonded to the rear surface.

As shown in FIG. **3B,** the solid state image pickup element **14** is placed in the middle of the cavity **12** of the substrate **10.** This is stored in a thermosetting oven at about 120 to 170°C for 2 hours such that the die bonding agent **19** is cured by heat. The thermal curing may preferably be carried out in nitrogen atmosphere from the aspect of preventing surface oxidation of the Al electrodes **15** of the solid state image pickup element **14.**

Then, as shown in FIG. **3C,** the Al electrodes **15** of the solid state image pickup element **14** are connected to the connection terminals **13** of the substrate **10** with the Au wires **16** by ball bonding. The connection may be achieved by wedge bonding instead of the ball bonding and the Au wires may be replaced with Al or Cu wires. In this way, the Al electrodes **15** of the solid state image pickup element **14,** Au wires **16,** connection terminals **13,** external side electrodes **17** and external bottom electrodes **18** are electrically connected.

Then, as shown in FIG. **3D,** a resin adhesive **20** is applied to the top surface of the topmost layer **21** of the substrate **10** using a dispenser.

Thereafter, as shown in FIG. **3E,** a transparent component **11** is placed on the topmost layer **21** of the substrate **10** such that the cavity **12** of the substrate **10** is covered with the transparent component **11.**

Subsequently, preliminary heating is carried out under certain conditions to temporarily fix the transparent component **11** onto the substrate **10** and then the top surface of the transparent component **11** is irradiated with UV light. The UV light irradiation initiates the polymerization of the resin adhesive **20,** thereby curing the resin adhesive **20** and bonding the transparent component **11** to the substrate **10.** The UV light preferably has a wavelength of 300 nm or higher and illumination of 200 mW or higher.

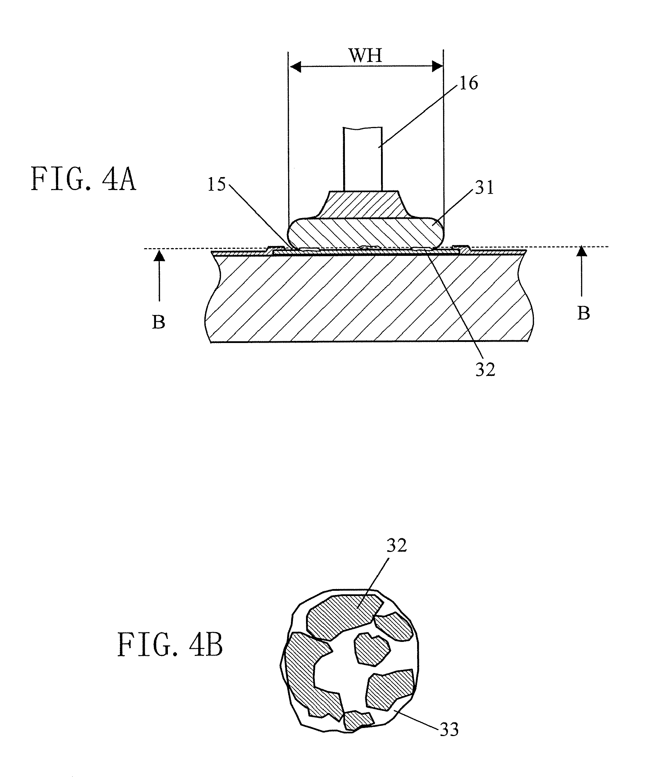

FIG. **4A** is a schematic sectional view illustrating the joint between the Al electrode **15** of the solid state image pickup element **14** and the Au wire **16.** According to an Au ball bonding method, the tips of the Au wires **16** are molten in advance and shaped into balls. The balls are then pressed onto the Al electrodes **15** while ultrasonic and thermal energies are applied thereon to create welds. As a result, the balls are shaped into flat nail heads **31.** The diameter WH of the nail head **31** becomes larger than that of the Au wire **16.** If the Au wire **16** has a diameter of 22.5 to 25.0 $\mu$m, the nail head **31** has a diameter WH of (40 to 95) $\pm$ 10 $\mu$m. According to this process, a natural oxide film formed on the Al electrodes **15** is torn and the Au wires are brought into contact with the new Al surface. Thus, an Au-Al alloy layer **32** is formed.

In the Au ball bonding method, the output of ultrasonic energy, bonding load and bonding temperature are varied to control the ratio of the alloy formed.

FIG. **4B** is a schematic cross sectional view taken along the line B-B shown in FIG. **4A.** The Au-Al alloy **32** may be made of $Au_4Al$. Referring to the cross sectional view, the ratio of the area occupied by the Au-Al alloy **32** contributes to the mechanical strength of the Al wires **16** and the Al electrodes **15.** That is, the mechanical strength of the Al wires **16** and the Al electrodes **15** increases as the ratio of the alloy area increases. The area of the Au-Al alloy **32** and that of unalloyed part **33** of the nail head are calculated by image analysis using an X-ray diffraction photograph of the vicinity of the Al electrode taken from above. Then, by the following equation, the ratio of the Au-A1 alloy is calculated and referred to as a parameter of the mechanical strength.

$$\text{The alloy ratio (\%)} = 100 \times \text{(Au-Al alloy area)} / \text{(nail head contacting area)}$$

(Examples)

In the following examples, a fluid bisphenol F epoxy resin was used as the epoxy resin [A] of the resin adhesive **20**.
The polymerization initiators [B] used were:

B-1: diaryliodonium tetrakis(pentafluorophenyl)borate;
B-2: diaryliodonium hexafluoroantimonate;
B-3: triarylsulfonium hexafluoroantimonate; and
B-4: triarylsulfonium tetrakis(pentafluorophenyl)borate.

1,1-bis(t-butylperoxy) 3,3,5-trimethylcyclohexane was used as the organic peroxide [C] and talc was used as the filler [D].
The evaluation was performed in the following manner.

(1) THB test

The solid state image pickup element **14** was mounted on the substrate **10** and the transparent component **11** was bonded to the substrate **10** with the resin adhesive **20**. The resin adhesive **20** was irradiated with UV light of 365 nm with **15** J and heated at 120°C for 10 minutes to cure. Thus, the solid state image pickup device **1** was fabricated. Bias voltage of 12.5 V was applied to the solid state image pickup element **14** in 85°C and 85% RH environment and an electric test was performed every 200 hours. In Table 1, the cumulative sum of failed solid state image pickup elements **14** is indicated as a numerator and the total number of the samples as a denominator.

(2) High temperature high humidity storage test

The solid state image pickup device **1** was stored in 85°C and 85%RH environment. The Al electrodes **15** of the solid state image pickup element **14** were visually checked as to whether discoloration occurred or not after 500 and 1,000 hours. In Table 2, the cumulative sum of discolored solid state image pickup elements **14** is indicated as a numerator and the total number of the samples as a denominator.
Table 1 shows the THB test results in relation to the composition of the resin adhesive **20** and the Au-Al alloy ratio. Table 2 shows a relationship between the composition of the resin adhesive **20** and the number of samples in which the Al electrodes were corroded after the high temperature high humidity storage test.

Table 1

|  |  | Examples | | | | Comparative Examples | |
|---|---|---|---|---|---|---|---|
|  |  | 1 | 2 | 3 | 4 | 1 | 2 |
| Composition (wt%) |  |  |  |  |  |  |  |
| Epoxy resin [A] | A-1 | 68.0 | 68.0 | 68.0 | 68.0 | 68.0 | 68.0 |
| Polymerization initiator [B] | B-1 | 4.8 | 4.8 | 4.8 |  |  |  |
|  | B-2 |  |  |  |  | 0.8 |  |
|  | B-3 |  |  |  |  |  | 0.9 |
|  | B-4 |  |  |  | 4.7 |  |  |
| Organic peroxide [C] | C-1 | 0.1 | 0.1 | 0.1 | 0.1 | 0.1 | 0.1 |
| Filler [D] | D-1 | 27.1 | 27.1 | 27.1 | 27.2 | 31.1 | 31.0 |
| Au-Al alloy ratio (wt%) |  | 20.4 | 33.4 | 52.5 | 51.6 | 53.0 | 53.1 |
| THB test result |  |  |  |  |  |  |  |
| 200h |  | 0/24 | 0/24 | 0/24 | 0/24 | 0/24 | 0/24 |

(continued)

|  | | Examples | | | | Comparative Examples | |
|---|---|---|---|---|---|---|---|
|  | | 1 | 2 | 3 | 4 | 1 | 2 |
| 400h | | 0/24 | 0/24 | 0/24 | 0/24 | 1/24 | 0/24 |
| 600h | | 0/24 | 0/24 | 0/24 | 0/24 | 3/24 | 0/24 |
| 800h | | 0/24 | 0/24 | 0/24 | 0/24 | 11/24 | 0/24 |
| 1,000h | | 1/24 | 0/24 | 0/24 | 0/24 | 23/24 | 0/24 |
| 1,200h | | 4/24 | 1/24 | 0/24 | 0/24 | 24/24 | 0/24 |

Table 2

|  | | Examples | | Comparative Examples | |
|---|---|---|---|---|---|
|  | | 11 | 12 | 11 | 12 |
| Composition (wt%) | | | | | |
| Epoxy resin [A] | A-1 | 68.0 | 68.0 | 68.0 | 68.0 |
| Polymerization initiator [B] | B-1 | 4.8 | | | |
| | B-2 | | | 0.8 | |
| | B-3 | | | | 0.9 |
| | B-4 | | 4.7 | | |
| Organic peroxide [C] | C-1 | 0.1 | 0.1 | 0.1 | 0.1 |
| Filler [D] | D-1 | 27.1 | 27.2 | 31.1 | 31.0 |
| Au-Al alloy ratio (wt%) | | 52.5 | 51.5 | 31.1 | 31.0 |
| High temp. high humidity storage test | | | | | |
| 85°C 85%RH 500h | | 0/24 | 0/24 | 24/24 | 24/24 |
| 1,000h | | 0/24 | 0/24 | 24/24 | 24/24 |

Next, the THB test results shown in Table 1 are described below.

Example 2 and Comparative Example 1

In Example 2 and Comparative Example 1 shown in Table 1, the resin adhesives are different in composition, i.e., they contain different anions of onium salt in different amounts. The resin adhesive of Example 2 contains 4.8 wt% tetrakis(pentafluorophenyl)borate as the anion, while the resin adhesive of Comparative Example 1 contains 0.8 wt% hexafluoroantimonate as the anion.

In the THB test, none of the samples of Example 2 failed even after a lapse of 1,200 h. On the other hand, some of the samples of Comparative Example 1 failed after a lapse of 400 h and every sample failed in 1,200 h. Inspection of the failed parts showed that interfacial peeling was caused by the corrosion of the interface between the nail head **31** of the Au wire **16** and the Al electrode **15**. A cause of this phenomenon is presumably the difference in anion structure, i.e., the difference in bond energy between fluorine and carbon.

Examples 1 to 3

Examples 1 to 3 are different in Au-Al alloy ratio. The mechanical strength of the weld created by the nail head **31** of the Au wire **16** and the Al electrode **15** is dependent on the area of the Au-Al alloy. The higher the alloy ratio is, the better results are obtained in the THB test. However, it is necessary to raise stage temperature during the bonding in order to increase the alloy ratio, which is more likely to damage the on-chip lenses formed on the solid state image pickup element **14.**

Example 4 and Comparative Example 2

Both of the resin adhesives **20** of Example 4 and Comparative Example 2 shown in Table 1 contain an iodine-free polymerization initiator and triaryl sulfonium as a cation of the onium salt, but they contain different anions of onium salt in different amounts. The resin adhesive of Example 4 contains 4.8 wt% tetrakis(pentafluorophenyl)borate as the anion, while the resin adhesive of Comparative Example 2 contains 0.9 wt% hexafluoroantimonate as the anion. Although both of them showed good results in the THB test, their results were different in the high temperature high humidity storage test. The results of the high temperature high humidity storage test are described below with reference to Table 2.

Examples 11-12 and Comparative Examples 11-12

The resin adhesive of Example 11 has the same composition as that of Example 1, while the resin adhesive of Example 12 has the same composition as that of Example 4. The resin adhesive of Comparative Example 11 has the same composition as that of Comparative Example 1, while the resin adhesive of Comparative Example 12 has the same composition as that of Comparative Example 2. The adhesives of Examples 11 and 12 contain tetrakis(pentafluorophenyl)borate as the anion of the onium salt, while the adhesives of Comparative Examples 11 and 12 contains hexafluoroantimonate as the anion of the onium salt. In the high temperature high humidity storage test, all the Al electrodes **15** of the solid state image pickup elements **14** were discolored in 500 h and the corrosion was observed in every sample of Comparative Examples 11 and 12. On the other hand, such failure was not observed in the samples of Examples 11 and 12.

(Second Embodiment)

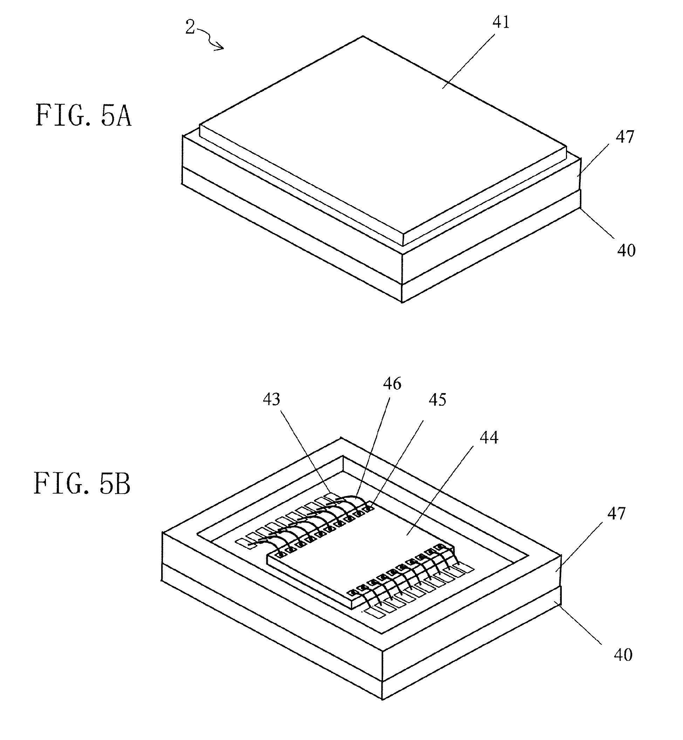

FIG. **5A** is a schematic perspective view of a solid state image pickup device **2** of a second embodiment and FIG. **5B** is a schematic perspective view of the solid state image pickup device **2** of FIG. **5A** from which a transparent component **41** and a resin adhesive **50** are removed.

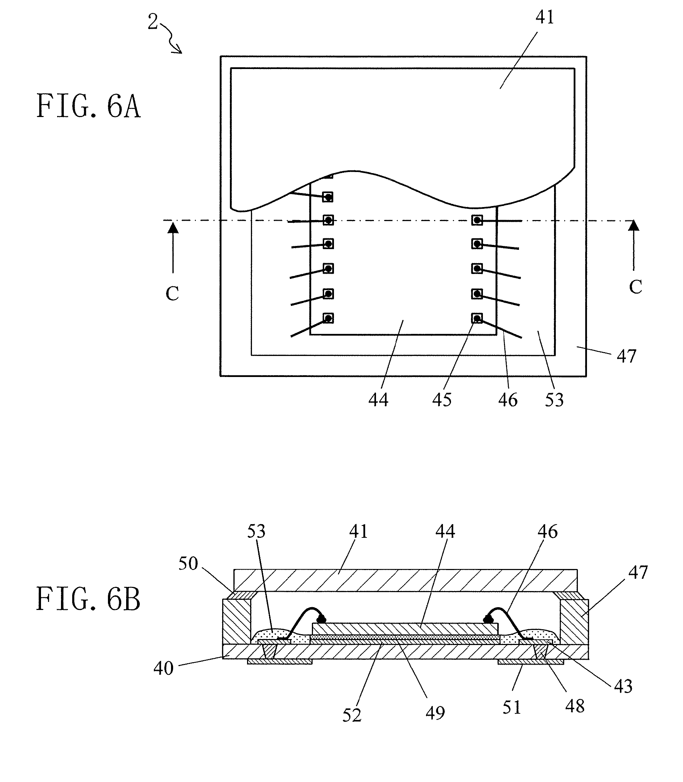

FIG. **6A** is a schematic plan view of the solid state image pickup device 2 of the present embodiment and FIG. **6B** is a sectional view taken along the line C-C of FIG. **6A.**

The solid state image pickup device 2 of the present embodiment includes a substrate **40** having a rib **47** formed on the periphery thereof, a die pattern **52** formed on the middle of the substrate **40,** a solid state image pickup element **44** bonded onto the die pattern **52** with a die bonding agent **49,** Au wires **46** for electrically connecting connection terminals **43** formed on the substrate **40** and Al electrodes (bonding pads) **45** of the solid state image pickup element **44,** an ion adsorbent **53** provided between the solid state image pickup element **44** and the rib **47,** a transparent component **41** bonded onto the rib **47** to cover the solid state image pickup element **44** and a resin adhesive **50** sandwiched between the rib 47 and the transparent component **41.**

On one of the surfaces of the substrate **40,** a mount region for mounting the solid state image pickup element **44** is defined. The die pattern **52** is provided in the mount region and electrically connected to the solid state image pickup element **44.** The plurality of connection terminals **43** are provided in a region of the substrate **40** between the mount region and a region for forming the rib **47.** Conductive parts **48** penetrating the substrate **40** are provided such that they are connected to parts of the connection terminals **43** more outside than the joints with the Au wires **46.** Further, external connection terminals **51** are formed on the other surface of the substrate **40** to be connected to the conductive parts **48.** The connection terminals **43** are radially arranged with respect to the mount region.

The substrate **40** of the present embodiment is a resin substrate. Various kinds of resin substrates may be used. For example, a resin substrate may be prepared by immersing organic fiber such as glass fiber or Kevlar® with an epoxy resin, a phenol resin or a polyimide resin and curing the resin. Or alternatively, a BT resin substrate may be used. In the present embodiment, the BT resin substrate is used. Therefore, the substrate **40** is referred to as a resin substrate **40.**

A copper foil is formed on the surface of the resin substrate **40** and patterned into desired shape by photolithography and etching.

For example, a copper foil of about 1.8 $\mu$m thickness is adhered onto both surfaces of the BT resin substrate **40** of about 0.2 mm thickness. After through holes are formed, a copper layer (not shown) is formed on the surface of the resin substrate **40** covered with the copper foil by a combined use of electroless plating and electroplating. During this time, the copper plating layer is formed on the inner surfaces of the through holes. Then, the die pattern **52,** connection terminals **43,** conductive parts **48** and external connection terminals **51** as shown in FIGS. **6A** and **6B** are formed by photolithography and etching. A thin gold film (not shown) is formed on the surfaces of the die pattern **52,** connection terminals **43,** conductive parts **48** and external connection terminals **51.** The thin gold film is provided by forming a nickel plating layer on the copper pattern and forming a gold plating layer on the nickel plating layer. This configuration improves bondability in bonding the Au wires **46** to the connection terminals **43** and solder wettability of the external connection terminals **51.** Thus, reliability at the joints is improved.

The rib **47** is a resin frame and easily obtained by molding a resin, such as a liquid crystal polymer, polyphenylenesulfide or polyethyleneterephthalate, and fixed onto the substrate **40** with a thermosetting resin adhesive (not shown). Alternatively, a plurality of resin substrates **40** connected to each other in the form of a sheet may be prepared in advance and the rib **47** may be formed thereon by transfer molding using a biphenyl epoxy resin or a phenol novolac epoxy resin, followed by dicing the sheet into individual substrates.

The die bonding agent **49** may be made of thermosetting resin paste such as an epoxy resin or a polyimide resin, or an adhesive tape. If high heat transfer property is required, it is preferable to use resin paste with a metallic filler such as Ag dispersed therein.

The resin adhesive **50** may be a thermosetting resin or a UV curable resin. The UV curable resin is preferable because it is less likely to cause thermal damage to the solid state image pickup element, especially to the on-chip lenses formed in an image pickup region of the solid state image pickup element **44,** and reduces time for curing the resin adhesive and cycle time of the manufacture.

The ion adsorbent **53** may be a fluid epoxy resin mixed with a filler such as calcium peroxide or hydrotalcite. Preferable examples of the fluid epoxy resin include bisphenol epoxy resins, novolac epoxy resins and biphenyl epoxy resins. Among the bisphenol epoxy resins, a bisphenol A epoxy resin, a bisphenol S epoxy resin and a bisphenol F resin are preferable and generally used because they are in the liquid state at room temperature. The ion adsorbent 53 may be contained in the die bonding agent.

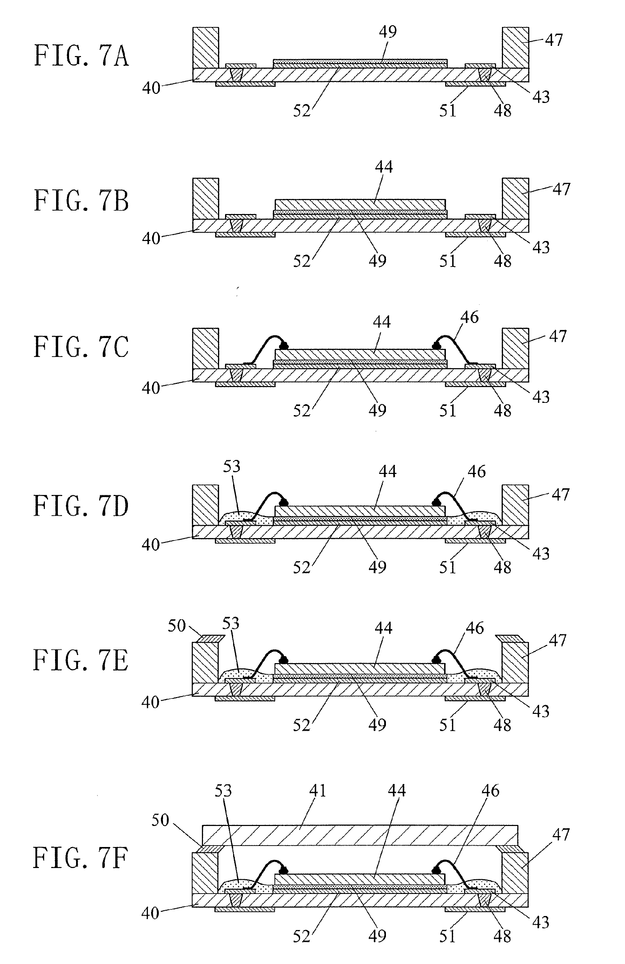

Hereinafter, brief explanation of a method for manufacturing the solid state image pickup device **2** of the present embodiment is provided with reference to FIGS. **7A** to **7F.**

Referring to FIG. **7A,** a die bonding agent **49** is applied to the die pattern **52** of the resin substrate **40** using a dispenser. The dispenser may have a single nozzle or multiple nozzles. The die bonding agent **49** may be provided by a transfer method. The die bonding agent **49** may be thermosetting paste containing a thermosetting resin such as an epoxy resin or a polyimide resin as a main ingredient. The epoxy resin may preferably be bisphenol epoxy resins, novolac epoxy resins or biphenyl epoxy resins. Among the bisphenol epoxy resins, a bisphenol A epoxy resin, a bisphenol S epoxy resin and a bisphenol F epoxy resin are preferable and generally used because they are in the liquid state at room temperature. If high heat transfer property is required, it is preferable to use resin paste with a metallic filler such as Ag dispersed therein. The thermosetting resin paste may be replaced with an adhesive tape. The adhesive tape is bonded to the rear surface of a wafer before separating the solid state image pickup elements **44** by dicing such that it is cut together with the solid state image pickup elements. In this way, the solid state image pickup elements are provided with the adhesive tape bonded to the rear surface.

As shown in FIG. **7B,** the solid state image pickup element **44** is placed on the die pattern **52** of the resin substrate **40.** This is stored in a thermosetting oven at about 120 to 170°C for 2 hours such that the die bonding agent **49** is cured by heat. The thermal curing may preferably be carried out in nitrogen atmosphere from the aspect of preventing surface oxidation of the Al electrodes **45** of the solid state image pickup element **44.**

Then, as shown in FIG. **7C,** the Al electrodes **45** of the solid state image pickup element **44** are connected to the connection terminals **43** of the substrate **40** with the Au wires **46** by ball bonding. The connection may be achieved by wedge bonding instead of the ball bonding and the Au wires **46** may be replaced with Al or Cu wires. In this way, the Al electrodes **45** of the solid state image pickup element **44,** Au wires **46,** connection terminals **43,** conductive parts **48** and external bottom electrodes **51** are electrically connected.

Then, as shown in FIG. **7D,** an ion adsorbent **53** is applied to a region between the rib **47** and the solid state image pickup element **44.** The ion adsorbent **53** may be thermally cured. Since the ion adsorbent **53** is capable of adsorbing ions liberated from the resin adhesive **50,** the reliability of the solid state image pickup element **44** is improved.

Then, as shown in FIG. **7E,** the resin adhesive **50** is applied onto the rib **47** using a dispenser.

Then, as shown in FIG. **7F,** a transparent component **41** is placed on the rib **47** to cover the solid state image pickup element **44** bonded to the die pattern **52** of the resin substrate **40.**

Subsequently, preliminary heating is carried out under certain conditions to temporarily fix the transparent component **41** onto the rib **47** and then the top surface of the transparent component **41** is irradiated with UV light. The UV irradiation initiates the polymerization of the resin adhesive **50,** thereby curing the resin adhesive **50** and bonding the transparent component **41** to the rib **47.** The UV light preferably has a wavelength of 300 nm or higher and illumination of 200 mW or higher.

In the present embodiment, the resin substrate **40** may be replaced with a ceramic substrate. Alternatively, a cavity is formed in the middle of the resin substrate **40** and the solid state image pickup element **44** may be placed on the bottom thereof.

(Third Embodiment)

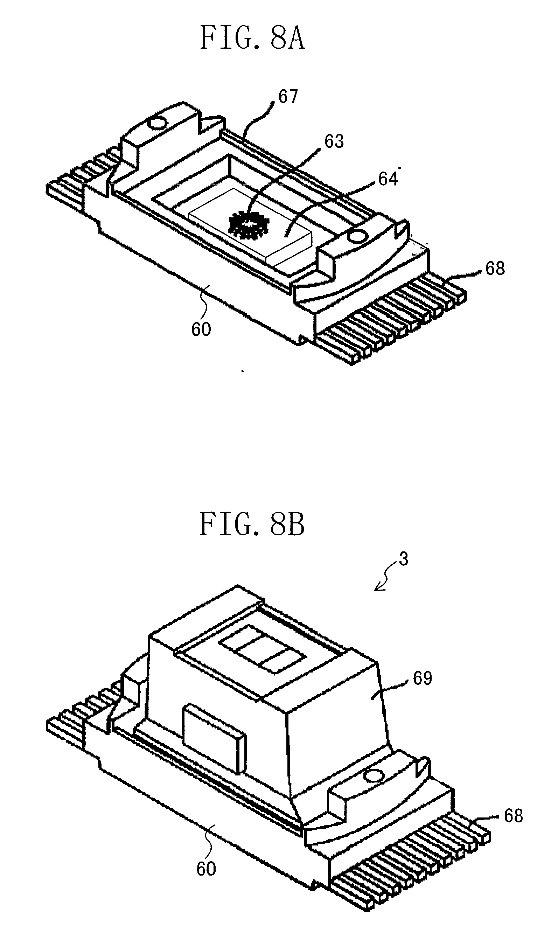

A semiconductor device of a third embodiment is a hologram unit **3** shown in FIGS. **8A** and **8B**. The hologram unit **3** is provided with semiconductor elements, i.e., a light receiving element **64** having a light receiving region as an active region and a laser element **63** having a light emitting region as an active region. These semiconductor elements are placed in a recess formed in a substrate **60.** Connection terminals formed on the substrate **60** and bonding pads of the semiconductor elements are connected to each other with Au wires. The substrate **60** is a combination of a resin housing and a lead frame including die pads and leads. A rib **67** is formed on the top surface of a sidewall of the substrate that defines the recess such that an adhesive for bonding a cover **69** to the top surface of the sidewall does not spill over onto the outer surface of the sidewall. Further, external leads **68** are configured to protrude from part of the outer wall of the substrate **60** for external connection.

In the hologram unit 3 of the present embodiment, the cover **69** for covering the recess in the substrate **60** including the light receiving element **64** and the laser element **63** is bonded to the substrate **60** with a resin adhesive. The cover **69** is a transparent hologram capable of selectively refracting light of a certain wavelength when it passes through the cover **69.**

The resin adhesive for bonding the substrate **60** and the cover **69** is the same as that used in the first embodiment. With use of the resin adhesive, an alloy layer formed on the interface between the Au wires and the Al electrodes of the semiconductor element is prevented from corrosion. Therefore, the semiconductor device is provided with high reliability.

(Fourth Embodiment)

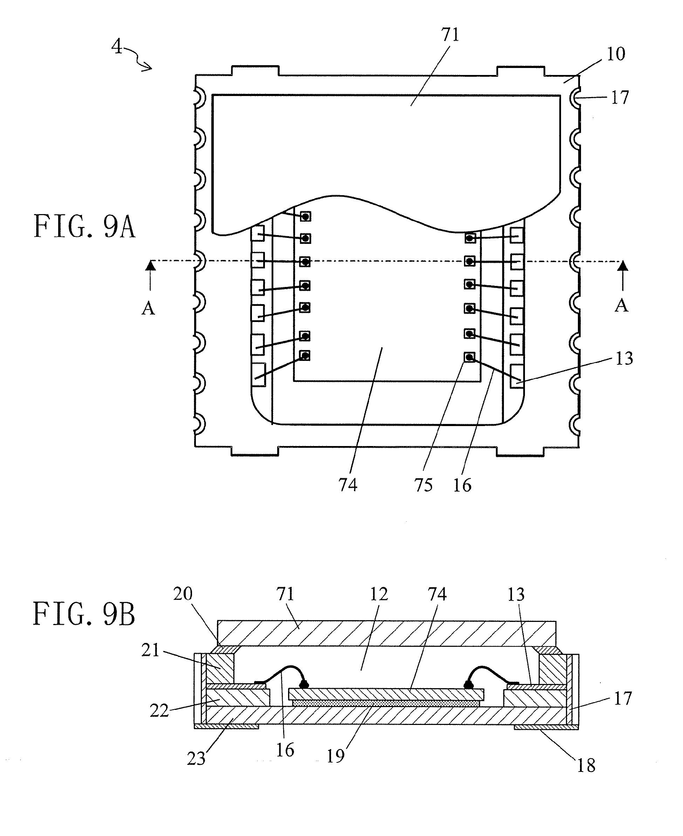

A semiconductor device **4** of a fourth embodiment shown in FIGS. **9A** and **9B** has the same structure as the solid state image pickup device of the first embodiment except that a pressure sensor element **74** is mounted on the substrate **10** as a semiconductor element instead of the solid state image pickup element. With this structure, the connection between the bonding wires **16** and electrodes 75 of the semiconductor element is achieved with high reliability under high temperature and high humidity conditions. In the present embodiment, a cover **71** need not be transparent and various kinds of material may be used for the cover **71,** such as metal, plastic and ceramic.

(Fifth Embodiment)

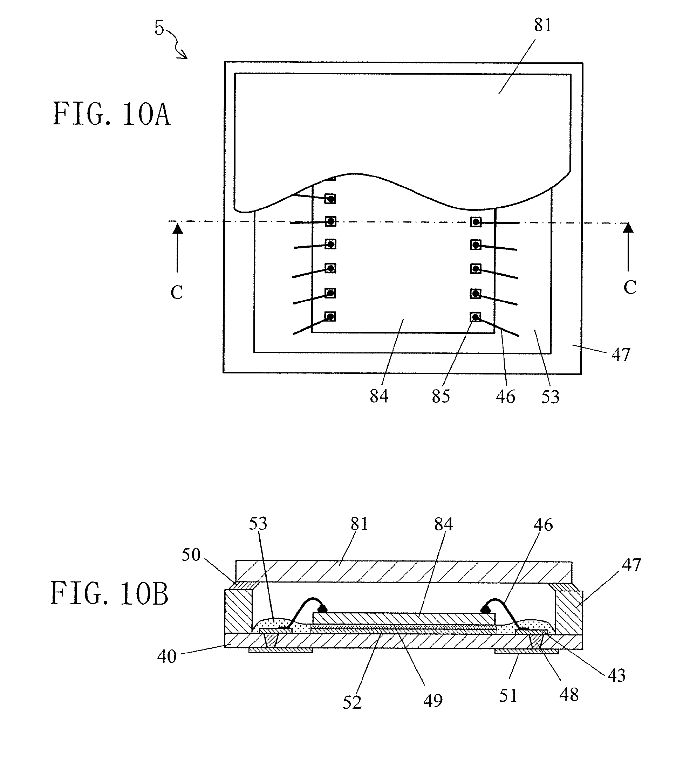

A semiconductor device 5 of a fifth embodiment shown in FIGS. **10A** and **10B** has the same structure as the solid state image pickup device of the second embodiment except that an acceleration sensor element **84** is mounted on the substrate **40** as a semiconductor element instead of the solid state image pickup element. With this structure, the connection between the bonding wires **46** and electrodes **85** of the semiconductor element is achieved with high reliability under high temperature and high humidity conditions. In the present embodiment, a cover **81** need not be transparent and various kinds of material may be used for the cover **81,** such as metal, plastic and ceramic.

(Other Embodiments)

The foregoing embodiments are described merely for the explanation of the present invention and the invention is not limited thereto. In the first and second embodiments, the solid state image pickup element used as the semiconductor element may be replaced with another light receiving element such as a photodiode, an LED or a laser light emitting element.

A sound sensor element, a pressure sensor element and an acceleration sensor element are also contained in the housing and enclosed therein not to have influence from outside. These sensors may be used as the semiconductor elements in the above-described embodiments. In this case, the cover need not be transparent. The active regions of the sound sensor element, pressure sensor element and acceleration sensor element are semiconductor regions that functions as sensors.

According to the solid state image pickup device of the present invention, an alloy layer formed on the interface between Au wires and Al electrodes of the solid state image pickup element is prevented from corrosion. Therefore, the solid state image pickup device is provided with improved reliability.

INDUSTRIAL APPLICABILITY

According to the solid state image pickup device and the method for manufacturing the same of the present invention, a resin adhesive is cured in a short time to bond a transparent component to a substrate without causing thermal damage on a solid state image pickup element. Thus, the solid state image pickup device is provided with high reliability.

**Claims**

1. A solid state image pickup device comprising:

   a solid state image pickup element including an image pickup region and a plurality of bonding pads;
   a substrate having a recess and containing the solid state image pickup element;
   a plurality of connection terminals formed in the recess of the substrate;
   Au wires for electrically connecting the bonding pads and the connection terminals;
   a transparent component placed on a top surface of the substrate; and
   a resin adhesive for bonding the substrate and the transparent component, wherein
   the resin adhesive contains an epoxy resin, a polymerization initiator and organic peroxide and the polymerization initiator contains onium salt having a halogen-containing aromatic compound as an anion.

2. A solid state image pickup device comprising:

   a solid state image pickup element including an image pickup region and a plurality of bonding pads;
   a substrate on which the solid state image pickup element is mounted;
   a rib formed on the substrate;
   a plurality of connection terminals formed on the substrate;
   Au wires for electrically connecting the bonding pads and the connection terminals;
   a transparent component placed above the substrate and bonded to a top surface of the rib; and
   a resin adhesive for bonding the top surface of the rib and the transparent component, wherein
   the resin adhesive contains an epoxy resin, a polymerization initiator and organic peroxide and the polymerization initiator contains onium salt having a halogen-containing aromatic compound as an anion.

3. The solid state image pickup device of Claim 1 or 2, wherein the halogen-containing aromatic compound is a fluorine-containing aromatic compound.

4. The solid state image pickup device of any one of Claims 1 to 3, wherein the halogen-containing aromatic compound is a borate compound.

5. The solid state image pickup device of any one of Claims 1 to 4, wherein the content of the polymerization initiator is higher than 0.5 wt% and less than 7 wt%.

6. The solid state image pickup device of any one of Claims 1 to 5, wherein

   the bonding pads of the solid state image pickup element are Al electrodes and
   the ratio of an alloy formed on an interface between the Au wires and the Al electrodes is 50% or higher.

7. The solid state image pickup device of any one of Claims 1 to 6, wherein the substrate is a ceramic substrate.

8. The solid state image pickup device of any one of Claims 1 to 6, wherein the substrate is a resin substrate.

9. The solid state image pickup device of any one of Claims 1 and 3 to 8, wherein an ion adsorbent is placed in the recess of the substrate.

10. The solid state image pickup device of any one of Claims 2 to 8, wherein an ion adsorbent is placed in a region enclosed with the top surface of the substrate and the rib.

11. A method for manufacturing a solid state image pickup device comprising the steps of:

    mounting a solid state image pickup element including an image pickup region and a plurality of bonding pads on a substrate having a recess;
    forming connection terminals on the substrate;
    electrically connecting the bonding pads of the solid state image pickup element and the connection terminals on the substrate with Au wires;
    applying a resin adhesive containing onium salt having a halogen-containing aromatic compound as an anion onto a top surface of the substrate; and

placing a transparent component on the top surface of the substrate and irradiating a top surface of the transparent component with UV light to cure the resin adhesive.

12. A method for manufacturing a solid state image pickup device comprising the steps of:

mounting a solid state image pickup element including an image pickup region and a plurality of bonding pads on a substrate;
forming connection terminals on the substrate;
electrically connecting the bonding pads of the solid state image pickup element and the connection terminals on the substrate with Au wires;
forming a rib in the form of a frame on the substrate;
applying a resin adhesive containing onium salt having a halogen-containing aromatic compound as an anion onto a top surface of the rib; and
placing a transparent component on the top surface of the rib and irradiating a top surface of the transparent component with UV light to cure the resin adhesive.

13. A semiconductor device comprising:

a semiconductor element including an active region and a plurality of bonding pads;
a substrate having a recess and containing the semiconductor element;
a plurality of connection terminals formed in the recess of the substrate;
Au wires for electrically connecting the bonding pads and the connection terminals;
a cover placed on a top surface of the substrate; and
a resin adhesive for bonding the substrate and the cover, wherein
the resin adhesive contains an epoxy resin, a polymerization initiator and organic peroxide and the polymerization initiator contains onium salt having a halogen-containing aromatic compound as an anion.

14. A semiconductor device comprising:

a semiconductor element including an active region and a plurality of bonding pads;
a substrate on which the semiconductor element is mounted;
a rib formed on the substrate;
a plurality of connection terminals formed on the substrate;
Au wires for electrically connecting the bonding pads and the connection terminals;
a cover placed above the substrate and bonded to a top surface of the rib; and
a resin adhesive for bonding the top surface of the rib and the transparent component, wherein
the resin adhesive contains an epoxy resin, a polymerization initiator and organic peroxide and the polymerization initiator contains onium salt having a halogen-containing aromatic compound as an anion.

15. The semiconductor device of Claim 13 or 14, wherein the halogen-containing aromatic compound is a fluorine-containing aromatic compound.

16. The semiconductor device of Claim 13 or 14, wherein the halogen-containing aromatic compound is a borate compound.

17. The semiconductor device of any one of Claims 13 to 16, wherein the content of the polymerization initiator is higher than 0.5 wt% and less than 7 wt%.

18. The semiconductor device of any one of Claims 13 to 17, wherein

the bonding pads of the semiconductor element are Al electrodes and
the ratio of an alloy formed on an interface between the Au wires and the Al electrodes is 50% or higher.

19. The semiconductor device of any one of Claims 13 to 18, wherein the substrate is a ceramic substrate.

20. The semiconductor device of any one of Claims 13 to 18, wherein the substrate is a resin substrate.

21. The semiconductor device of any one of Claims 13 and 15 to 20, wherein an ion adsorbent is placed in the recess of the substrate.

22. The semiconductor device of any one of Claims 14 to 20, wherein an ion adsorbent is placed in a region enclosed with the top surface of the substrate and the rib.

23. The semiconductor device of any one of Claims 13 to 22, wherein the semiconductor element is a sound sensor element, a pressure sensor element or an acceleration sensor element.

24. The semiconductor device of any one of Claims 13 to 22, wherein the semiconductor element is a laser element, an LED or a photodiode and the cover is a transparent component.

25. A method for manufacturing a semiconductor device comprising the steps of:

mounting a semiconductor element including an active region and a plurality of bonding pads on a substrate having a recess;
forming connection terminals on the substrate;
electrically connecting the bonding pads of the semiconductor element and the connection terminals on the substrate with Au wires;
applying a resin adhesive containing onium salt having a halogen-containing aromatic compound as an anion onto a top surface of the substrate; and
placing a cover on the top surface of the substrate and irradiating a top surface of the cover with UV light to cure the resin adhesive.

26. A method for manufacturing a semiconductor device comprising the steps of:

mounting a semiconductor element including an active region and a plurality of bonding pads on a substrate;
forming connection terminals on the substrate;
electrically connecting the bonding pads of the semiconductor element and the connection terminals on the substrate with Au wires;
forming a rib in the form of a frame on the substrate;
applying a resin adhesive containing onium salt having a halogen-containing aromatic compound as an anion onto a top surface of the rib; and
placing a cover on the top surface of the rib and irradiating a top surface of the cover with UV light to cure the resin adhesive.

27. The method of Claim 25 or 26, wherein the semiconductor element is a laser element, an LED or a photodiode and the cover is a transparent component.

28. A solid state image pickup device comprising:

a solid state image pickup element including an image pickup region and a plurality of bonding pads;
a substrate having a recess and containing the solid state image pickup element;
a plurality of connection terminals formed in the recess of the substrate;
Au wires for electrically connecting the bonding pads and the connection terminals;
a transparent component placed on a top surface of the substrate; and
a resin adhesive for bonding the substrate and the transparent component, wherein
the resin adhesive contains an epoxy resin and a polymerization initiator and the polymerization initiator contains onium salt having a halogen-containing aromatic compound as an anion.

29. A solid state image pickup device comprising:

a solid state image pickup element including an image pickup region and a plurality of bonding pads;
a substrate on which the solid state image pickup element is mounted;
a rib formed on the substrate;
a plurality of connection terminals formed on the substrate;
Au wires for electrically connecting the bonding pads and the connection terminals;
a transparent component placed above the substrate and bonded to a top surface of the rib; and
a resin adhesive for bonding the top surface of the rib and the transparent component, wherein

the resin adhesive contains an epoxy resin and a polymerization initiator and the polymerization initiator contains onium salt having a halogen-containing aromatic compound as an anion.

**30.** A semiconductor device comprising:

a semiconductor element including an active region and a plurality of bonding pads;
a substrate having a recess and containing the semiconductor element;
a plurality of connection terminals formed in the recess of the substrate;
Au wires for electrically connecting the bonding pads and the connection terminals;
a cover placed on a top surface of the substrate; and
a resin adhesive for bonding the substrate and the cover, wherein
the resin adhesive contains an epoxy resin and a polymerization initiator and the polymerization initiator contains onium salt having a halogen-containing aromatic compound as an anion.

**31.** A semiconductor device comprising:

a semiconductor element including an active region and a plurality of bonding pads;
a substrate on which the semiconductor element is mounted;
a rib formed on the substrate;
a plurality of connection terminals formed on the substrate;
Au wires for electrically connecting the bonding pads and the connection terminals;
a cover placed above the substrate and bonded to a top surface of the rib; and
a resin adhesive for bonding the top surface of the rib and the cover, wherein
the resin adhesive contains an epoxy resin and a polymerization initiator and the polymerization initiator contains onium salt having a halogen-containing aromatic compound as an anion.

FIG. 1A

10

1

11

17

FIG. 1B

16

13

12

15

14

FIG. 2A

FIG. 2B

FIG. 3A

FIG. 3B

FIG. 3C

FIG. 3D

FIG. 3E

FIG. 4A

FIG. 4B

FIG. 5A

FIG. 5B

FIG. 6A

2

41

C

C

44    45    46    53

47

FIG. 6B

53    41    44    46

50

47

40

52    49    51    48

43

FIG. 7A

FIG. 7B

FIG. 7C

FIG. 7D

FIG. 7E

FIG. 7F

# FIG. 8A

# FIG. 8B

FIG. 9A

FIG. 9B

FIG. 10A

FIG. 10B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H10321749 A
- JP 2004022928 A
- JP 2000264955 A